# EUROPÄISCHE PATENTANMELDUNG

(11) **EP 2 113 942 A2**
(43) Veröffentlichungstag der Anmeldung: **04.11.2009**
(21) Anmeldenummer: 09158438.3
(22) Anmeldetag: 22.04.2009
(51) Int. Cl.: H01L 25/16, H01L 33/00

(54) **LED-Modul mit Rahmen und Leiterplatte**

(30) Priorität: 30.04.2008 DE 102008021661
(71) Anmelder: Ledon Lighting Jennersdorf GmbH, 8380 Jennersdorf (AT)
(72) Erfinder: Hartmann, Paul, 8160, Weiz (AT)
(74) Vertreter: Rupp, Christian

(57) **Zusammenfassung**

Ein LED-Modul weist auf:
- einen LED-Chip (1), der sichtbares Licht ausstrahlt und auf einer Leiterplatte (2) aufgebracht ist, auf der Leiterbahnen angeordnet sind,
- einen den LED-Chip (1) seitlich in einem Abstand umgebenden Rahmen (3), und
- eine zumindest die Oberseite des LED-Chips (1) bedeckende Vergussmasse,
- wenigstens ein in den Rahmen (3) integriertes oder an dem Rahmen (3) angeordnetes opto-elektronisches und/oder elektronisches Bauteil (4) für den Betrieb des LED-Chips (1), das mit dem LED-Chip (1) verbunden ist.

## Beschreibung

Die vorliegende Erfindung bezieht sich allgemein auf das Gebiet von LED-Modulen, also sichtbares Licht emittierenden Modulen, die einen oder mehrere LED-Hableiterchips einer oder mehrere Farben aufweisen.

Aus der WO2006/048064 A1 ist eine LED in Chip-On-Board Struktur mit einem umgebenden Reflektor bekannt, der in engem Abstand (bis zu 0,5 mm) um den LED-Chip und diesen in der Höhe überragend angeordnet ist. Dieser Reflektor dient dazu, einerseits eine Farbkonversionsschicht oder einen transparenten Verguss einzufassen, andererseits das von der LED abgestrahlte Licht in vorteilhafter Weise durch Reflexion der seitlich emittierten Strahlungen zu bündeln, und so eine effizientere und/oder homogenere Abstrahlung über den gesamten Raumwinkel zu erreichen. Dieser Reflektor hat jedoch lediglich die Funktion der Lichtlenkung und der Einfassung von Farbkonversionsmaterial.

SMT-LED-Packages unter Verwendung von Silizium sind aus der EP 1848042A1 bekannt.

US 6169295B1 beschreibt einen IR-Transceiver, der IR-Strahlung in Richtung eines externen Empfängers oder Gegenstandes aussendet und über den integrierten Sensor externe IR-Strahlung aus Richtung eines externen Senders oder Gegenstandes empfängt. Der integrierte Sensor ist also nicht für sichtbares Licht ausgelegt

Weiters sind keramische SMT-LED-Packages oder solche aus Polymer-Komposit-Material als Stand der Technik bekannt.

Es ist nunmehr Aufgabe der vorliegenden Erfindung, eine besonders vorteilhafte Integration von elektronischen Bauteilen oder Schaltungen in ein LED-Modul zu ermöglichen.

Die Aufgabe der Erfindung wird gelöst durch die Merkmale der unabhängigen Ansprüche. Die abhängigen Ansprüche bilden den zentralen Gedanken der Erfindung in besonders vorteilhafter Weise weiter.

Gemäss einem ersten Aspekt der Erfindung ist ein LED-Modul vorgesehen, aufweisend:
- einen oder mehrere LED-Chips, der vorzugsweises Licht im sichtbaren Spektrum emittiert und auf einer Leiterplatte aufgebracht ist, auf der Leiterbahnen angeordnet sind,
- einen den LED-Chip seitlich in einem Abstand umgebenden Rahmen, und
- eine den Raum zwischen dem LED-Chip und dem Rahmen füllende sowie die Oberseite des LED-Chips bedeckende Vergussmasse,
- wenigstens ein in den Rahmen integriertes oder an dem Rahmen angeordnetes optoelektronisches und/oder elektronisches Bauteil für den Betrieb des LED-Chips, das mit dem LED-Chip verbunden ist.

Der Rahmen ist vorzugsweise aus einem elektrisch nichtleitenden Grundmaterial gefertigt ist.

Der Rahmen kann entweder aus Keramik, Glas, Polymeren, Polymer-komposites, Karbon, Fiberglas oder Silizium, oder aus einer Kombination dieser Materialien bestehen.

Das Bauteil kann ausgewählt sein aus einem oder mehreren der Gruppe aufweisend einen Photosensor (Lichtsensor für das Licht des LED-Chips), Temperatursensor, Farbsensor, eine Konstantstromquelle, Thermo-Sicherheitsschalter, Thermowiderstand, Datenspeicher, Funkempfänger, IR-Empfänger und RFID-Tag.

Der Photosensor ist dabei ausgebildet, als Lichtsensor eine oder mehrere Farben im sichtbaren Spektrum von einem oder mehreren LED-Chips desselben LED-Moduls zu erfassen, wobei das Licht von dem LED-Chip vorzugsweise direkt auf den Lichtsensor trifft.

Der LED-Chip kann zumindest indirekt mit zumindest einer Drahtverbindung mit dem Bauteil des Rahmens verbunden sein.

Der LED-Chip kann über die Leiterplattenbahnen zumindest indirekt mit dem Bauteil des Rahmens verbunden sein.

Der LED-Chip kann in Chip-on-Board-Technik auf der Leiterplatte aufgebracht sein.

Der Abstand zwischen der Basis des Rahmens und der Basis des LED-Chips kann vorzugsweise weniger als 0,5 mm betragen.

Die Vergussmasse kann Farbkonversionsmaterial und/oder Streupartikel enthalten.

Der Rahmen kann wenigstens eine Durchkontaktierung aufweisen, die elektrisch mit einer Elektrode des LED-Chips verbunden ist.

Das Bauteil kann insbesondere auf der Oberseite des Rahmens und/oder zwischen dem Rahmen und der Oberseite der Leiterplatte angeordnet sein.

Insbesondere kann der Rahmen derart ausgeführt sein, dass er über einen Flip-Chip Bond-Prozess auf der Leiterplatte befestigt werden kann.

Ein weiterer Aspekt der Erfindung bezieht sich auf ein Verfahren zur Herstellung eines LED-Moduls, bei dem:
- ein LED-Chip sowie ein Rahmen über einen Chip-on-Board-Prozess auf einer Leiterplatte angebracht werden,
- eine elektrische Verbindung zwischen dem LED-Chip und dem Rahmen hergestellt wird, und
- in die Zwischenräume zwischen dem Rahmen und dem LED-Chip sowie über dem LED-Chip ein transparentes Vergussmaterial oder ein Farbkonversionsmaterial gefüllt und ausgehärtet wird.

Weitere Vorteile, Merkmale und Eigenschaften der vorliegenden Erfindung werden nunmehr anhand von Ausführungsbeispielen und unter Bezugnahme auf die Figuren der begleitenden Zeichnungen näher erläutert.
- Figur 1: zeigt ein erstes Ausführungsbeispiel mit einem vertikalen oder Face-Up LED-Chip,
- Figur 2: zeigt ein zweites Ausführungsbeispiel mit einem vertikalen oder Face-Up LED-Chip, das sich gegenüber dem ersten Ausführungsbeispiel durch Durchkontaktierungen ("Vias") im Rahmen unterscheidet,
- Figur 3: zeigt ein zweites Ausführungsbeispiel mit einem Flip-Chip LED-Chip, und
- Figur 4: zeigt ein weiteres Ausführungsbeispiel mit einem Face-Up ("FU") LED-Chip.

Wie in sämtlichen Figuren weist ein LED-Modul im Sinne der Erfindung eine Leiterplatte 2 mit einem oder mehreren darauf bspw. in Chip-on-board-Technolgie (COB) geklebten oder gelöteten LED-Halbleiterchip(s) 1 auf, der bzw. die von einem Rahmen 3 allseitig umschlossen wird, der einen Luftspalt 12 zwischen LED-Chip 1 und Rahmen 3(vorzugsweise < 0,5 mm breit) einfasst, wobei zumindest die Oberfläche 13 des LED-Chips 1 von Vergussmaterial bedeckt wird, welches vorzugsweise den durch den Rahmen 3 definierten Raum eben ausfüllt. Der Luftspalt zwischen LED-Chip und Rahmen ist vorzugsweise mit Vergussmaterial (transparent oder mit Farbkonversions-Leuchtstoffen) 5 gefüllt.

Der LED-Chip 1 ist also vorzugsweise nicht auf einer Silizium-Plattform oder einem "Submount" oder "Supporting Frame" montiert, sondern direkt auf einer Leiterplatte 2 mit Leiterbahnen auf ihrer Oberseite. Die Montageart hat den Vorteil der besseren Wärmeabfuhr und der Möglichkeit zur Bildung eines LED-Feldes innerhalb eines Rahmens, der mehrere LED-Chips 1 der gleichen oder unterschiedlicher Farben (bspw. RGB) einschliesst.

Der LED-Chip 1 ist entweder vom Flip-Chip-Typ (beide Elektroden zur Leiterplatte 2 gewendet), oder vom vertikalen Typ (eine Elektrode zur Leiterplatte, die andere nach oben gerichtet), oder vom Face-Up-Typ (beide Elektroden nach oben gerichtet.

Der Rahmen 3 dient:
a. als geometrische Begrenzung der Farbkonversionsschicht bzgl. deren seitlichen und vertikalen Erstreckung,
b. als Reflexionskörper für Strahlung des LED-Chips 1 und der Farbkonversionsschicht 5, und/oder
c. als Substrat für eine Elektronik-Schicht 4, die vorzugsweise elektronische Bauteile 7 enthält, die zum Betrieb des LED-Chips 1 benötigt werden.

Der Rahmen 3 kann zusätzlich mit einem Material mit hohem Reflexionsgrad beschichtet sein und vertikale oder nach Aussen geneigte Wände aufweisen. Die Höhe des Rahmens 3 beträgt typischerweise 150 bis 1000µm. Der Spalt 12 zwischen LED-Seitenkante und dem unteren Ansatz (Basis) der Innenwand des Rahmens 3 beträgt vorzugsweise max. 0,5 mm. Die Innenwand des Rahmens 3 ist vorzugsweise parallel zur Richtung der LED-Seitenkante, kann aber auch bis zu 60° nach außen geneigt sein. Beispielsweise liefern gewisse Ätztechniken in Silizium eine Kavität, deren Wände um 45° nach außen geneigt sind.

Das Basis-Material des Rahmens 3 ist bevorzugt nicht leitend und besteht beispielsweise aus Keramik, Polymeren, Glas, Polymerkomposit, Carbon, Fiberglas oder Silizium, oder aber aus Schichten von Silizium und isolierenden Materialien (SOI u.a.). Auf einer Seite (Seitenfläche, Oberseite oder Basis) des Rahmens 3 ist eine elektronische Struktur 4 aufgebracht. Diese elektronische Struktur 4 kann ein Bauteil 7 oder eine Schaltung aufweisen wie bspw. eine Konstantstromquelle, einen Lichtsensor (für eine oder mehrere sichtbare Farben), einen Temperatursensor, eine Temperatur-Schutzschaltung, etc..

Vorzugsweise hat das Bauteil 7 eine Funktion zum Betrieb (Ansteuerung, Regelung, Spannungsversorgung, ...) des LED-Chips 1 und steht in diesem Fall mit diesem direkt oder indirekt elektrisch oder zumindest signaltechnisch in Verbindung.

Die elektronische Struktur 4 kann beispielsweise auf der Oberfläche einer den Rahmen 3 bildenden Keramik (oder eines Glases oder Polymers) durch physikalische oder chemische Abscheideprozesse (CVD, PVD), oder durch Siebdruckverfahren, Photolithographie und entsprechende Maskierung, oder ähnliche gängige Verfahren aufgebracht werden.

In einer weiteren Ausführungsform besteht der Rahmen 3 aus einem photosensitiven Polymer.

In einer weiteren Ausführungsform besteht der Rahmen 3 aus Silizium und die elektronische Struktur 4 wird beispielsweise durch eine Silicon-On-Insulator (SOI) oder eine CMOS-Technologie (wie z.B. Bicmos) aufgebracht.

Die elektronische Struktur 4 kann generell einen einschichtigen oder einen mehrschichtigen Aufbau haben.

Zum Zwecke der Kontaktierung der Elektroden des LED-Chips 1 (ausgenommen der direkt an der Leiterplatte kontaktierte LED Flip-Chip) sind zumindest ein oder mehrere Bonddrähte 6 vorgesehen. Die Elektroden des LED-Chips 1 sind entweder direkt oder indirekt mit der elektronischen Struktur 4 des Rahmens 3 durch solche Bonddrähte 6 verbunden (indirekt wäre bspw. über eine Leiterbahn auf der Oberseite der Leiterplatte 2).

Ausführungsformen können auch mehrere LED-Chips innerhalb eines einzigen Rahmens 3 beinhalten.

Die Geometrie des Rahmens 4 ist vorzugsweise, aber nicht notwendigerweise durch parallel zu den Seitenkanten des LED-Chips 1 ausgerichtete Innenwände gekennzeichnet. Diese Ausnehmung im Inneren des Rahmens 3 kann beispielsweise durch mechanische Verfahren, chemisches Ätzen, Laserabtragung oder Plasma-Ätzen erzeugt werden. Ist das Substrat des Rahmens 3 ein photosensitives Polymer, kann die Ausnehmung auch durch photolithografische Verfahren erzeugt werden (Maskierung des Rahmens 3 ).

In einer Ausführungsform als Weisslicht-LED kann der Rahmen 3 genaue geometrische Abmessungen haben, um eine möglichst homogene Abstrahlung (Farbkonstanz über den Raumwinkel) zu gewährleisten.

### Herstellungsverfahren

Für Vertikale oder Face-Up LEDs:
Ein LED-Chip (LED-die) 1 sowie ein Rahmen 3, auf den eine vorgefertigte elektronische Struktur 4 angebracht wurde, wird über einen Chip-on-Board-Prozess auf eine Leiterplatte 2 platziert (geklebt oder gelötet), wobei die Reihenfolge zunächst egal ist. An die Elektroden des LED-Chips 1 und des Rahmens 3 bzw. der Platine (Leiterplatte ) 2 werden Verbindungsdrähte 6 gebondet, und in die Zwischenräume 12 sowie über dem LED-Chip 1 wird ein transparentes oder mit Leuchtstoffen und anderen Zusatzstoffen (bspw. Streupartikel) versetztes Vergussmaterial 5 gefüllt und ausgehärtet. Zum Schutz der Drähte wird gegebenenfalls eine zusätzliche Schutzversiegelung 8 angebracht.
Für Flip-Chip LEDs:
   Eine LED-Flip-Chip ("LED die") sowie ein Rahmen, auf den eine vorgefertigte elektronische Struktur sowie für Flip-Chip-Montage geeignete Kontakte angebracht wurden, wird mittels eines Chip-on-Board-Prozesses auf eine Leiterplatte platziert (geklebt oder gelötet), wobei die Reihenfolge zunächst egal ist. Der Rahmen wird mit der elektronischen Struktur zur Leiterplatte hin direkt mit dieser verbunden. Verbindungsdrähte und Schutzversiegelung sind nicht nötig.

Weitergehende Details der Erfindung werden nunmehr unter Bezugnahme auf die einzelnen Figuren beschrieben.

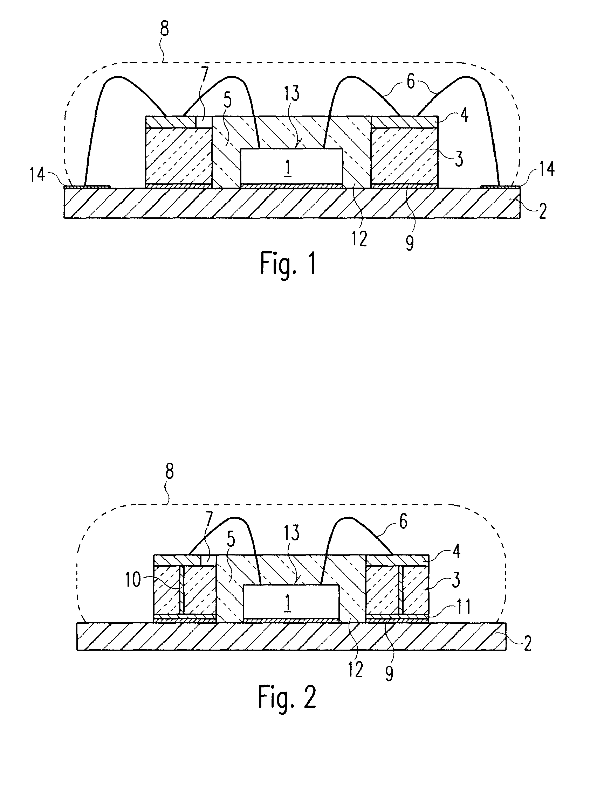

Figur 1 zeigt eine erste Ausführungsform eines LED-Moduls basierend auf einem vertikalen LED-Chip 1 (gilt gleichermaßen für Face-Up LED): Die elektronische Struktur 4 ist auf der Oberseite des Rahmens 3 angebracht. Zur Kontaktierung mit dem LED-Chip 1 werden Drahtverbindungen (Bonddrähte) 6 gezogen. Ebenso wird die Verbindung der elektronischen Struktur 4 mit den Leiterbahnen 14 der Leiterplatte 2 über Drahtverbindungen 6 hergestellt. Die Drahtverbindungen 6 werden vorzugsweise durch eine transparente Schutzversiegelung 8 abgedeckt. Ein Sensor (für sichtbares Licht und/oder Temperatur) 7 oder ein anderes Bauteil ist vorzugsweise in der gleichen Ebene wie die restliche Elektronik 4 angebracht.

Figur 2 zeigt eine der Figur 1 vergleichbare Ausgestaltung, jedoch sind hier elektrisch leitende und vorzugsweise metallische Durchkontaktierungen 10 vorgesehen, die bspw. in einem Rahmen 3 aus Keramik oder Silizium gefertigt werden. Damit können die auf die Leiterplatte (PCB) 2 führenden Drähte 6 des Ausführungsbeispiels von Figur 1 ersetzt werden.

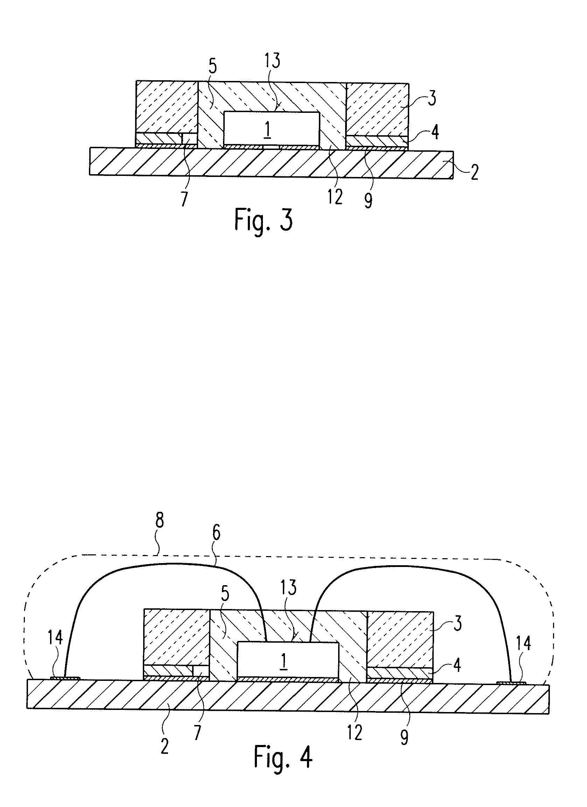

Bei der Ausführungsform von Figur 3: ist sowohl der Rahmen 3 mit der elektronischen Struktur 4 als auch der LED-Chip 1 als "Flip-Chip" ausgeführt. Somit ist bei der Montage des Rahmens 3 auf die Leiterplatte 2 die zu kontaktierende Elektronikschicht 4 nach unten, d.h. direkt auf die Leiterplatte 2 gerichtet. Dadurch können sowohl der Rahmen 3 wie auch der LED-Chip 2 direkt mit den Leiterbahnen der Leiterplatte 2 kontaktiert werden. Der Rahmen 3 wird dabei mit einer speziellen Flip-Chip Technologie gefertigt (zB. Gold-bump-Kontakten oder ähnlichem). Die Leiterplatte 2 hat entsprechende Strukturen, um die Verschaltung, d.h. elektrische Kontaktierung mit den nach unten gerichteten Elektroden des LED-Chips 1 und des Rahmens 3 zu gewährleisten. Diese Ausführung benötigt vorzugsweise keine Drahtverbindungen und keine Durchkontaktierungen. Allerdings kann es von Vorteil sein, wenn die Elektronik-Schicht 4 mehrlagig ausgestaltet ist.

Die Ausgestaltung von Figur 4 zeigt einen Flip-chip-Rahmen 3, also einen Rahmen 3 mit zur Leiterplatte 2 weisender Elektronikschicht 4, kombiniert mit einem vertikal aufgebauten oder einem Face-Up LED-Chip 1, der an seiner Oberseite wenigstens eine Elektrode aufweist, die mit einer Drahtverbindung kontaktiert wird, wobei vorzugsweise der Bonddraht über den Rahmen 3 hinweg zu Leiterbahnen auf der Oberseite der Leiterplatte 2 ausserhalb des Rahmens 3 führt.

## Patentansprüche

1. LED-Modul, aufweisend:
- einen LED-Chip (1), der auf einer Leiterplatte (2) aufgebracht ist, auf der Leiterbahnen angeordnet sind, wobei der LED-Chip vorzugsweise Licht im sichtbaren Spektrum emittiert,
- einen den LED-Chip (1) seitlich in einem Abstand umgebenden Rahmen (3), und
- eine zumindest die Oberseite des LED-Chips (1) bedeckende Vergussmasse (5),
- wenigstens ein in den Rahmen (3) integriertes oder an dem Rahmen (3) angeordnetes optoelektronisches und/oder elektronisches Bauteil (4) für den Betrieb des LED-Chips (1), das mit dem LED-Chip (1) verbunden ist.

2. LED-Modul nach Anspruch 1,
bei dem der Rahmen (3) aus einem elektrisch nichtleitenden Grundmaterial gefertigt ist.

3. LED-Modul nach einem der Ansprüche 1 oder 2,
dass der Rahmen aus einem oder mehreren Materialien aus der Gruppe von Keramik, Glas, Polymeren, Polymer-komposites, Karbon, Fiberglas und Silizium besteht.

4. LED-Modul nach einem der vorhergehenden Ansprüche,
bei dem das Bauteil (4) zumindest eine Funktion aus der Gruppe eines Photosensors, Temperatursensors, Farbsensors, einer Konstantstromquelle, eines Thermo-Sicherheitsschalters, Thermowiderstandes, Datenspeichers, Funkempfängers oder RFID-Tags beinhaltet.

5. LED-Modul nach Anspruch 4,
bei dem der Photosensor dazu ausgebildet ist, sichtbares Licht einer oder mehrerer Farben von dem LED-Chip desselben LED-Moduls zu detektieren.

6. LED-Modul nach einem der vorhergehenden Ansprüche,
bei dem der LED-Chip (1) zumindest indirekt mit zumindest einer Drahtverbindung (6) mit dem Bauteil (4) des Rahmens (3) verbunden ist.

7. LED-Modul nach einem der vorhergehenden Ansprüche,
bei dem der LED-Chip (1) über die Leiterplattenbahnen zumindest indirekt mit dem Bauteil (4) des Rahmens(3) verbunden ist.

8. LED-Modul nach einem der vorhergehenden Ansprüche,
bei dem der LED-Chip (1) in Chip-on-Board-Technik auf der Leiterplatte (2) aufgebracht ist.

9. LED-Modul nach einem der vorhergehenden Ansprüche, wobei der Abstand zwischen der Basis des Rahmens (3) und der Basis des LED-Chips (1) weniger als 0,5 mm beträgt.

10. LED-Modul nach einem der vorhergehenden
Ansprüche,
bei dem die Vergussmasse Farbkonversionsmaterial und/oder Streupartikel enthält.

11. LED-Modul nach einem der vorhergehenden Ansprüche, bei dem der Rahmen (3) wenigstens eine Durchkontaktierung aufweist, die elektrisch mit einer Elektrode des LED-Chips (1) verbunden ist.

12. LED-Modul nach einem der vorhergehenden Ansprüche, bei dem das Bauteil (4) auf der Oberseite des Rahmens (3) und/oder zwischen dem Rahmen (3) und der Oberseite der Leiterplatte (2) angeordnet ist.

13. LED-Modul nach einem der vorhergehenden Ansprüche, bei dem das Vergussmaterial den Raum zwischen dem LED-Chip (1) und dem Rahmen (3) füllt.

14. Verfahren zur Herstellung eines LED-Moduls, bei dem
- ein LED-Chip (1) sowie ein Rahmen (3) über einen Chip-on-board-Prozess auf einer Leiterplatte (2) angebracht werden,
- eine elektrische Verbindung zwischen dem LED-Chip (1) und dem Rahmen (3) hergestellt wird, und
- zumindest über dem LED-Chip (1) ein transparentes Vergussmaterial oder ein Farbkonversionsmaterial gefüllt und ausgehärtet wird.

15. Verfahren nach Anspruch 13, bei dem zusätzlich das transparente Vergussmaterial oder das
Farbkonversionsmaterial in die Zwischenräume zwischen dem Rahmen (3) und dem LED-Chip (1)gefüllt und ausgehärtet wird.
